(19) **Europäisches Patentamt / European Patent Office / Office européen des brevets**

(11) **EP 4 411 398 B1**

(12) **EUROPEAN PATENT SPECIFICATION**

(45) Date of publication and mention
of the grant of the patent:
**14.01.2026 Bulletin 2026/03**

(21) Application number: **22874532.9**

(22) Date of filing: **31.08.2022**

(51) International Patent Classification (IPC):
*H02P 29/024* (2016.01)   *H02P 21/14* (2016.01)
*H02P 21/22* (2016.01)   *G01R 31/34* (2020.01)
*G01R 31/42* (2006.01)

(52) Cooperative Patent Classification (CPC):
**G01R 31/343; G01R 31/42; H02P 21/14;
H02P 21/22; H02P 29/0243**

(86) International application number:
**PCT/CN2022/116241**

(87) International publication number:
**WO 2023/051141 (06.04.2023 Gazette 2023/14)**

(54) **PHASE FAILURE DIAGNOSIS METHOD BASED ON CURRENT INSTRUCTION RECONSTRUCTION AND NEGATIVE SEQUENCE CURRENT EXTRACTION**

VERFAHREN ZUR DIAGNOSE VON PHASENAUSFALL AUF DER BASIS VON STROMBEFEHLSREKONSTRUKTION UND STROMEXTRAKTION NEGATIVER SEQUENZEN

PROCÉDÉ DE DIAGNOSTIC DE DÉFAILLANCE DE PHASE BASÉ SUR LA RECONSTRUCTION D'INSTRUCTIONS DE COURANT ET L'EXTRACTION DE COURANT DE SÉQUENCE NÉGATIVE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.09.2021 CN 202111158000**

(43) Date of publication of application:
**07.08.2024 Bulletin 2024/32**

(73) Proprietor: **Bosch Huayu Steering Systems Co.,
Ltd.
Shanghai 201821 (CN)**

(72) Inventors:
• **ZHAO, Yu**
**Shanghai 201821 (CN)**
• **ZHAI, Yu**
**Shanghai 201821 (CN)**
• **LI, Shuo**
**Shanghai 201821 (CN)**
• **GAO, Peng**
**Shanghai 201821 (CN)**
• **DIAO, Guoliang**
**Shanghai 201821 (CN)**

(74) Representative: **Bittner, Bernhard
Hannke Bittner & Partner
Patent- und Rechtsanwälte mbB
Prüfeninger Strasse 1
93049 Regensburg (DE)**

(56) References cited:
EP-A1- 3 696 965   EP-A2- 2 741 418
CN-A- 101 927 700   CN-A- 101 963 655
CN-A- 102 411 111   CN-A- 103 620 944
CN-A- 105 099 325   CN-A- 105 143 894
CN-A- 111 736 071   JP-A- 2016 077 103
US-A1- 2010 320 953   US-A1- 2013 077 194
US-A1- 2014 054 103

• BAKHRI SYAIFUL: "Detailed Investigation of Negative Sequence Current Compensation Technique for Stator Shorted Turn Fault Detection of Induction Motors", SCHOOL OF ELECTRICAL AND ELECTRONIC ENGINEERING FACULTY OF ENGINEERING, COMPUTER AND MATHEMATICAL SCIENCE, 1 March 2013 (2013-03-01), pages 1 - 192, XP093212578, Retrieved from the Internet <URL:https://digital.library.adelaide.edu.au/dspace/bitstream/2440/83536/8/02whole.pdf> [retrieved on 20241008]

**(Cont. next page)**

- "Grid Converters for Photovoltaic and Wind Power Systems", 28 August 2011, JOHN WILEY & SONS, ISBN: 978-1-119-95720-1, article TEODORESCU REMUS ET AL: "Control of Grid Converters under Grid Faults Grid Converters for Photovoltaic and Wind Power Systems", pages: 237 - 287, XP093212570

## Description

TECHNICAL FIELD

The present disclosure relates to the technical field of EPS motor, specifically to a phase failure diagnosis method based on current instruction reconstruction and negative sequence current extraction.

BACKGROUND

With the rapid development of automobile industry, the level of automobile electrization is getting higher and higher, and the consumer's requirement for driving experience becomes higher and higher. Electric Power Steering (EPS) is a power steering system directly based on motor to provide auxiliary torque, which requires very high requirement for its safety performance. Therefore, once the electric power steering system fails, it needs to be detected out and switched to safe mode in time.

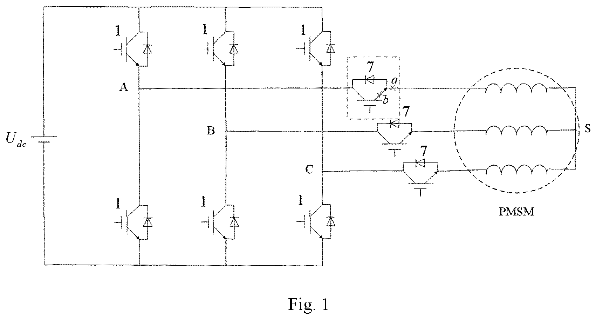

At present, the monophase phase failure diagnosis of most motor-driven products is completed by the way of power on self-inspection. However, when there is a phase failure during the motor operates, it cannot be diagnosed, identified and take corresponding safety actions, which causes high safety risk to the users of the products. For example, the driving topology diagram of three-phase two electrical levels by EPS motor is shown as Figure 1, when a circuit break is happened on the power device 1 in the driving circuit, it can be detected by the driving chip, but when a circuit break is happened on the phase separation MOSFET7, for example, point A or point B is disconnected, it is unable to be detected and identified.

Therefore, it is necessary to design a phase failure diagnosis method based on current instruction reconstruction and negative sequence current extraction in order to detect and identify the circuit break caused by the phase separation MOSFET.

D1 (US20130077194A1) discloses a method for protecting an electric propulsion system from malfunction of one or more current sensors that measure phase currents into windings Wa, Wb, Wc of a drive motor, the current sensors providing indicated motor phase current signals Ia, Ib, Ic, the method comprising: receiving from the current sensors indicated motor phase current signals Ia, Ib, Ic; receiving a motor torque command T* from a command input source; receiving a motor rotation speed $\omega$r from the motor; receiving a direct current (dc) voltage Vdc from a dc source supplying the drive currents to the motor windings Wa, Wb, Wc; using T*, $\omega$r, and Vdc, obtaining values for time varying direct axis command current Id* and quadrature axis command current Iq*; determining values for total command current Is=((Id*)$^2$+(Iq*)$^2$)$^{1/2}$; determining values for negative current In=($\frac{1}{3}$)*(Ia+$\alpha^2$Ib+$\alpha$Ic) where $\alpha$=e$^{j2\pi/3}$; determining values for normalized negative current Inn=In/Is; and comparing Inn to a predetermined threshold value INN*, and if Inn>INN*, executing a control action, to prevent damage to the motor and/or to other elements of the propulsion system supplying energy to the motor and/or providing a soft or hard shut-down to minimize risk to any personnel.

D2 (US20100320953A1) discloses an electrical system for use in a vehicle, the electrical system comprising: an electric motor having stator windings; an energy source; an inverter module coupled between the energy source and the stator windings, the inverter module being configured to provide a commanded voltage from the energy source to the stator windings of the electric motor; a plurality of current sensors coupled between the inverter module and the stator windings, the plurality of current sensors being configured to measure current through the stator windings, resulting in measured current; and a control module coupled to the inverter module and the plurality of current sensors, the control module being configured to: obtain a current command corresponding to a commanded current for the stator windings of the electric motor; generate a voltage command corresponding to the commanded voltage based on a difference between the measured current and the commanded current; determine a negative sequence voltage for the stator windings based on the voltage command; and identify a fault condition in the stator windings based on the negative sequence voltage component. The stator windings of the electric motor may be constantly monitored, thereby allowing an incipient or early stage fault condition to be readily identified and mitigating the adverse effects of a fault condition.

D3 (EP3696965A1) discloses a control method for a motor drive device including: an inverter that supplies an alternating-current power to an electric motor; and a current sensor that measures a direct-current bus current of the inverter, the method comprising the steps of: comparing a q-axis current measurement calculated based on an output of the current sensor and an estimated q-axis current value estimated based on a q-axis voltage command value; and determining whether the current sensor is abnormal based on a duration of deviation that is a duration of continuous deviation of the q-axis current measurement from the estimated q-axis current value. Abnormality diagnostic unit increments (increases) the NG counter using the duration.

SUMMARY

The object of the present invention is to overcome the deficiency of the prior art, providing a phase failure diagnosis method based on current instruction reconstruction and negative sequence current extraction, in order to detect and identify the circuit break caused by the phase separation MOSFET.

In order to achieve the above purposes, the present invention provides a phase failure diagnosis method based on current instruction reconstruction and negative sequence current extraction according to the amended independent claim 1.

In step 1, the formulas for calculating the d-axis current instruction value $i_{dref}$, q-axis current instruction value $i_{qref}$

are: $$i_{qref} = \frac{T_e}{1.5 P_n [\psi_f + (L_d - L_q) i_d]},$$

$$b = \frac{2 R_s \omega_e i_q (L_d - L_q) + 2 \omega_e^2 \psi_f L_d}{R_s^2 + \omega_e^2 L_d^2},$$

$$c = \frac{(R_s^2 + \omega_e^2 L_d^2) i_q^2 + 2 R_s \omega_e i_q \psi_f + \omega_e^2 \psi_f^2 - u_{lim}^2}{R_s^2 + \omega_e^2 L_d^2},$$

$$i_{dref} = \frac{-b + \sqrt{b^2 - 4c}}{2},$$

wherein, $T_e$ is electromagnetic torque, $P_n$ is pole logarithm of the motor, $\psi_f$ is magnetic flux of a permanent magnet body, $L_d$ is d-axis inductance of the motor, $L_q$ is q-axis inductance of the motor, $i_d$ is d-axis current of the motor, $R_s$ is stator resistance of the motor, $\omega_e$ is current rotation speed of the motor, $i_q$ is q-axis current of the motor, and $u_{lim}$ is available voltage limit value.

The formulas for calculating the U-phase current reference value $i_{uref}$, the V-phase current reference value $i_{vref}$ and the W-phase current reference value $i_{wref}$ are:

$$\begin{bmatrix} i_{uref} \\ i_{vref} \\ i_{wref} \end{bmatrix} = \begin{bmatrix} 1 & 0 \\ -\frac{1}{2} & \frac{\sqrt{3}}{2} \\ -\frac{1}{2} & -\frac{\sqrt{3}}{2} \end{bmatrix} \begin{bmatrix} \cos\theta & -\sin\theta \\ \sin\theta & \cos\theta \end{bmatrix} \begin{bmatrix} i_{dref} \\ i_{qref} \end{bmatrix}, \quad i_{uref} = i_{dref}\cos\theta - i_{qref}\sin\theta,$$

$$i_{vref} = -\frac{1}{2}\left(i_{dref}\cos\theta - i_{qref}\sin\theta\right) + \frac{\sqrt{3}}{2}\left(i_{dref}\sin\theta + i_{qref}\cos\theta\right),$$

$$i_{wref} = -\frac{1}{2}\left(i_{dref}\cos\theta - i_{qref}\sin\theta\right) - \frac{\sqrt{3}}{2}\left(i_{dref}\sin\theta + i_{qref}\cos\theta\right),$$

wherein, $\theta$ is the rotation angle of the d-q coordinate system.

The current adjustment value $i_{threshold}$ is obtained by adjusting the current sampling level according to an actual product.

The N is determined according to a failure tolerance time based on functional safety and a running period of a diagnostic strategy.

Compared with the prior art, the present invention designs a phase failure diagnosis method based on current instruction reconstruction and negative sequence current extraction, and judge whether phase failure is happened or not by the difference between the reference negative sequence component and the negative sequence component of the U phase current, which can quickly and accurately diagnose the phase failure caused by the phase separation MOSFET of the motor under every working condition of EPS motor, and make the system enter into a safe state.

BRIEF DESCRIPTION OF THE DRAWINGS

Fig.1 is a driving topology diagram of EPS motor with three-phase two electrical levels in the prior art.

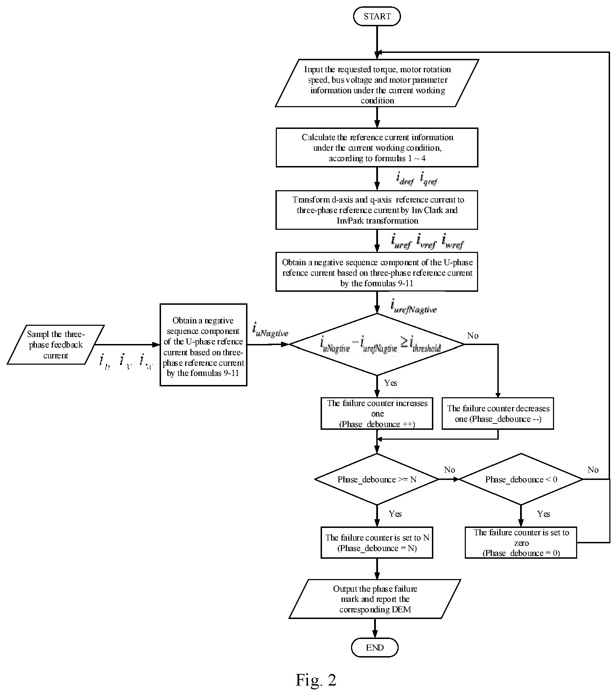

Fig. 2 is the flow chart of the phase failure diagnosis method in the present invention.

## DETAILED DESCRIPTION OF THE PREFERRED EMBODIMENT

The present invention is further described as following in combination with the figures.

As figure 1 shows, the present invention provides a phase failure diagnosis method based on current instruction reconstruction and negative sequence current extraction, comprising the following steps:

step 1, calculating a d-axis current instruction value $i_{dref}$, a q-axis current instruction value $i_{qref}$ of a motor according to the current torque, the rotating speed and the voltage of the motor.

the formulas for calculating the d-axis current instruction value $i_{dref}$, q-axis current instruction value $i_{qref}$ are:

$$i_{qref} = \frac{T_e}{1.5P_n[\psi_f + (L_d - L_q)i_d]},$$

$$b = \frac{2R_s\omega_e i_q(L_d - L_q) + 2\omega_e^2\psi_f L_d}{R_s^2 + \omega_e^2 L_d^2},$$

$$c = \frac{(R_s^2 + \omega_e^2 L_d^2)i_q^2 + 2R_s\omega_e i_q\psi_f + \omega_e^2\psi_f^2 - u_{lim}^2}{R_s^2 + \omega_e^2 L_d^2},$$

$$i_{dref} = \frac{-b + \sqrt{b^2 - 4c}}{2},$$

wherein, $T_e$ is electromagnetic torque, $P_n$ is pole logarithm of the motor, $\psi_f$ is magnetic flux of a permanent magnet body, $L_d$ is d-axis inductance of the motor, $L_q$ is q-axis inductance of the motor, $i_d$ is d-axis current of the motor, $R_s$ is stator resistance of the motor, $\omega_e$ is current rotation speed of the motor, $i_q$ is q-axis current of the motor, $u_{lim}$ is available voltage limit value.

Step 2, performing inverse Clark transformation and inverse Park transformation on the d-axis current instruction value $i_{dref}$ and the q-axis current instruction value $i_{qref}$ of the motor, to obtain a U-phase current reference value $i_{uref}$, a V-phase current reference value $i_{vref}$ and a W-phase current reference value $i_{wref}$.

The formulas for calculating the U-phase current reference value $i_{uref}$, the V-phase current reference value $i_{vref}$ and the W-phase current reference value $i_{wref}$ are:

$$\begin{bmatrix} i_{uref} \\ i_{vref} \\ i_{wref} \end{bmatrix} = \begin{bmatrix} 1 & 0 \\ -\frac{1}{2} & \frac{\sqrt{3}}{2} \\ -\frac{1}{2} & -\frac{\sqrt{3}}{2} \end{bmatrix} \begin{bmatrix} \cos\theta & -\sin\theta \\ \sin\theta & \cos\theta \end{bmatrix} \begin{bmatrix} i_{dref} \\ i_{qref} \end{bmatrix}, \quad i_{uref} = i_{dref}\cos\theta - i_{qref}\sin\theta,$$

$$i_{vref} = -\frac{1}{2}\left(i_{dref}\cos\theta - i_{qref}\sin\theta\right) + \frac{\sqrt{3}}{2}\left(i_{dref}\sin\theta + i_{qref}\cos\theta\right),$$

$$i_{wref} = -\frac{1}{2}\left(i_{dref}\cos\theta - i_{qref}\sin\theta\right) - \frac{\sqrt{3}}{2}\left(i_{dref}\sin\theta + i_{qref}\cos\theta\right),$$

wherein, $\theta$ is the rotation angle of the d-q coordinate system.

Step 3, calculating a reference negative sequence component of the U-phase current $i_{urefNagtive}$ according to the U-phase current reference value $i_{uref}$, the V-phase current reference value $i_{vref}$ and the W-phase current reference value $i_{wref}$.

The formulas for calculating the reference negative sequence component $i_{urefNagtive}$ of the U-phase current are:

$$x_{bref} = i_{vref}(t) - i_{vref}(t - \Delta t)\cos(\omega_e\Delta t) \cdot \cot(\omega_e\Delta t) - i_{vref}(t - \Delta t)\sin\omega_e\Delta t,$$

$$x_{cref} = i_{wref}(t) - i_{wref}(t - \Delta t)\cos(\omega_e\Delta t) \cdot \cot(\omega_e\Delta t) - i_{wref}(t - \Delta t)\sin\omega_e\Delta t,$$

$$i_{urefNagtive} = \frac{1}{3}\left(i_{uref} - \frac{1}{2}i_{vref} - \frac{1}{2}i_{wref} + \frac{\sqrt{3}}{2}x_{cref} - \frac{\sqrt{3}}{2}x_{bref}\right),$$

wherein, $i_{vref}(t)$ is V-phase current reference value at time t, $i_{wref}(t)$ is W-phase current reference value at time t, $i_{vref}(t - \Delta t)$ is V-phase current reference value at time $(t - \Delta t)$, $i_{wref}(t - \Delta t)$ is W-phase current reference value at time $(t - \Delta t)$, $\omega_e\Delta t$ is current phase position difference, $\Delta t$ is the time difference of the software's running cycle, $\omega_e$ is the electrical angular speed of the motor.

Step 4, calculating a negative sequence component $i_{uNagtive}$ of the U-phase current according to the three-phase current.

the formulas for calculating the negative sequence component $i_{uNagtive}$ of the U-phase current are:

$$x_b = i_v(t) - i_v(t - \Delta t)cot\omega_e\Delta t - i_v(t - \Delta t)sin\omega_e\Delta t,$$

$$x_c = i_w(t) - i_w(t - \Delta t)cot\omega_e\Delta t - i_w(t - \Delta t)sin\omega_e\Delta t,$$

$$i_{luagtive} = \frac{1}{3}\left(i_u - \frac{1}{2}i_v - \frac{1}{2}i_w + \frac{\sqrt{3}}{2}x_c - \frac{\sqrt{3}}{2}x_b\right),$$

wherein, $i_u$ is U-phase current feedback value, $i_v$ is V-phase current feedback value, $i_w$ is W-phase current feedback value, $i_v(t)$ is V-phase current feedback value at time t, $i_w(t)$ is W-phase current feedback value at time t, $i_v(t - \Delta t)$ is V-phase current feedback value at time $(t - \Delta t)$, $t_w(t - \Delta t)$ is W-phase current feedback value at time $(t - \Delta t)$.

Step 5, calculating a difference value $i_{urefNagtive} - i_{uNagtive}$ between the reference negative sequence component of the U-phase current $i_{urefNagtive}$ and the negative sequence component of the U-phase current $i_{uNagtive}$, in particular, if $i_{urefNagtive} - i_{uNagtive} \geq$ current adjustment value $i_{threshold}$, it indicates a failure occurred, then failure counter is increased by one, if $i_{urefNagtive} - i_{uNagtive} <$ current adjustment value $i_{threshold}$, it indicates the failure may be disappeared, then the failure counter is decreased by one. The current adjustment value $i_{threshold}$ is obtained by adjusting the current sampling level according to an actual product.

In step 5, the statistical number of the failure counter is the frequency number of the motor's failures during the statistical failure tolerance time. If a phase failure occurs, the reference negative sequence component basically is zero, but the negative sequence component calculated from the feedback current is a certain number, so the difference between the two parameters can be used to determine whether a phase failure has occurred or not.

Step 6, if the failure counter≥N, it indicates the failure has continually occurred for N times, which can be concluded that the failure really occurs , then set N and trigger a phase failure, if the failure counter<N, then execute step 7.

N is determined according to a failure tolerance time based on functional safety and a running period of a diagnostic strategy. For example, if the security requirement requires a failure tolerance time of 14 ms, and the running period of the failure detection algorithm is 1 ms, then the N value could be set to 14.

Step 7, if the failure counter<0, then set 0 and return back to step 1, and if the failure counter≥0, then return to step 1 directly.

Step 7 can prevent the failure counter from being reduced to a negative number.

In the embodiment of the present invention, the current instruction reconstruction and negative sequence current extraction are realized by steps 1 and 2, then whether a phase failure is occurred or not can be judged according to the difference between the reference negative sequence component and the negative sequence component, which can quickly and accurately diagnose the phase failure caused by the phase separation MOSFET under every working condition of EPS motor, and make the system enter into a safe state .

**Claims**

1. A phase failure diagnosis method based on current instruction reconstruction and negative sequence current extraction, comprising the following steps:

   step 1, calculating a d-axis current instruction value $i_{dref}$, a q-axis current instruction value $i_{qref}$ of a motor according to current torque, rotating speed and voltage of the motor;
   step 2, performing inverse Clark transformation and inverse Park transformation on the d-axis current instruction value $i_{dref}$ and the q-axis current instruction value $i_{qref}$ of the motor, to obtain a U-phase current reference value $i_{uref}$, a V-phase current reference value $i_{vref}$ and a W-phase current reference value $i_{wref}$;

step 3, calculating a reference negative sequence component $i_{urefNagtive}$ of the U-phase current according to the U-phase current reference value $i_{uref}$, the V-phase current reference value $i_{vref}$ and the W-phase current reference value $i_{wref}$;

formulas for calculating the reference negative sequence component of the U-phase current $i_{urefNagtive}$ are:

$$x_{bref} = i_{vref}(t) - i_{vref}(t - \Delta t)cos(\omega_e \Delta t) \cdot cot(\omega_e \Delta t) - i_{vref}(t - \Delta t)sin\omega_e \Delta t,$$

$$x_{cref} = i_{wref}(t) - i_{wref}(t - \Delta t)cos(\omega_e \Delta t) \cdot cot(\omega_e \Delta t) - i_{wref}(t - \Delta t)sin\omega_e \Delta t,$$

$$i_{urefNagtive} = \frac{1}{3}\left(i_{uref} - \frac{1}{2}i_{vref} - \frac{1}{2}i_{wref} + \frac{\sqrt{3}}{2}x_{cref} - \frac{\sqrt{3}}{2}x_{bref}\right),$$

wherein, $i_{vref}(t)$ is V-phase current reference value at time t, $i_{wref}(t)$ is W-phase current reference value at time t, $i_{vref}(t - \Delta t)$ is V-phase current reference value at time $(t - \Delta t)$, $i_{wref}(t - \Delta t)$ is W-phase current reference value at time $(t - \Delta t)$, and $\omega_e \Delta t$ is current phase position difference;

step 4, calculating a negative sequence component $i_{uNagtive}$ of the U-phase current according to the three-phase current;

formulas for calculating the negative sequence component $i_{uNagtive}$ of the U-phase current are:

$$x_b = i_v(t) - i_v(t - \Delta t)cot\omega_e \Delta t - i_v(t - \Delta t)sin\omega_e \Delta t,$$

$$x_c = i_w(t) - i_w(t - \Delta t)cot\omega_e \Delta t - i_w(t - \Delta t)sin\omega_e \Delta t,$$

$$i_{uNagtive} = \frac{1}{3}\left(i_u - \frac{1}{2}i_v - \frac{1}{2}i_w + \frac{\sqrt{3}}{2}x_c - \frac{\sqrt{3}}{2}x_b\right),$$

wherein, $i_u$ is U-phase current feedback value, $i_v$ is V-phase current feedback value, $i_w$ is W-phase current feedback value, $i_v(t)$ is V-phase current feedback value at time t, $i_w(t)$ is W-phase current feedback value at time t, $i_v(t - \Delta t)$ is V-phase current feedback value at time $(t - \Delta t)$, $i_w(t - \Delta t)$ is W-phase current feedback value at time $(t - \Delta t)$;

step 5, calculating a difference value $i_{urefNagtive} - i_{uNagtive}$ between the reference negative sequence component of the U-phase current $i_{urefNagtive}$ and the negative sequence component of the U-phase current $i_{uNagtive}$, if $i_{urefNagtive} - i_{uNagtive} \geq$ current adjustment value $i_{threshold}$, then failure counter is increased by one, if $i_{urefNagtive} - i_{uNagtive} <$ current adjustment value $i_{threshold}$, then the failure counter is decreased by one;

step 6, if the failure counter $\geq$ N, then set N and trigger a phase failure, and if the failure counter < N, then execute step 7;

step 7, if the failure counter < 0, then set 0 and return back to step 1, and if the failure counter $\geq$ 0, then return back to step 1 directly.

2. The phase failure diagnosis method based on current instruction reconstruction and negative sequence current extraction according to claim 1, wherein in step 1, formulas for calculating the d-axis current instruction value $i_{dref}$, q-axis current instruction value $i_{qref}$ are:

$$i_{qref} = \frac{T_e}{1.5P_n[\psi_f + (L_d - L_q)i_d]},$$

$$b = \frac{2R_s\omega_e i_q(L_d - L_q) + 2\omega_e^2\psi_f L_d}{R_s^2 + \omega_e^2 L_d^2},$$

$$c = \frac{(R_s^2 + \omega_e^2 L_d^2) i_q^2 + 2 R_s \omega_e i_q \psi_f + \omega_e^2 \psi_f^2 - u_{lim}^2}{R_s^2 + \omega_e^2 L_d^2},$$

$$i_{dref} = \frac{-b + \sqrt{b^2 - 4c}}{2},$$

wherein, $T_e$ is electromagnetic torque, $P_n$ is pole logarithm of the motor, $\psi_f$ is magnetic flux of a permanent magnet body, $L_d$ is d-axis inductance of the motor, $L_q$ is q-axis inductance of the motor, $i_d$ is d-axis current of the motor, $R_s$ is stator resistance of the motor, $\omega_e$ is current rotation speed of the motor, $i_q$ is q-axis current of the motor, $u_{lim}$ is available voltage limit value.

3. The phase failure diagnosis method based on current instruction reconstruction and negative sequence current extraction according to claim 1, wherein formulas for calculating the U-phase current reference value $i_{uref}$, the V-phase current reference value $i_{vref}$ and the W-phase current reference value $i_{wref}$ are:

$$\begin{bmatrix} i_{uref} \\ i_{vref} \\ i_{wref} \end{bmatrix} = \begin{bmatrix} 1 & 0 \\ -\frac{1}{2} & \frac{\sqrt{3}}{2} \\ -\frac{1}{2} & -\frac{\sqrt{3}}{2} \end{bmatrix} \begin{bmatrix} \cos\theta & -\sin\theta \\ \sin\theta & \cos\theta \end{bmatrix} \begin{bmatrix} i_{dref} \\ i_{qref} \end{bmatrix},$$

$$i_{uref} = i_{dref}\cos\theta - i_{qref}\sin\theta,$$

$$i_{vref} = -\frac{1}{2}\left(i_{dref}\cos\theta - i_{qref}\sin\theta\right) + \frac{\sqrt{3}}{2}\left(i_{dref}\sin\theta + i_{qref}\cos\theta\right),$$

$$i_{wref} = -\frac{1}{2}\left(i_{dref}\cos\theta - i_{qref}\sin\theta\right) - \frac{\sqrt{3}}{2}\left(i_{dref}\sin\theta + i_{qref}\cos\theta\right),$$

wherein, $\theta$ is the rotation angle of the d-q coordinate system.

4. The phase failure diagnosis method based on current instruction reconstruction and negative sequence current extraction according to claim 1, wherein the current adjustment value $i_{threshold}$ is obtained by adjusting the current sampling level according to an actual product.

5. The phase failure diagnosis method based on current instruction reconstruction and negative sequence current extraction according to claim 1, wherein the N is determined according to a failure tolerance time based on functional safety and a running period of a diagnostic strategy.

**Patentansprüche**

1. Verfahren zur Phasenausfalldiagnose auf der Grundlage einer Strombefehlsrekonstruktion und einer Negativsequenzstrom-Extraktion, welches die folgenden Schritte umfasst:

Schritt 1: Berechnen eines d-Achsen-Strombefehlswerts $i_{dref}$, eines q-Achsen-Strombefehlswerts $i_{qref}$ eines Motors entsprechend dem Stromdrehmoment, der Drehzahl und der Spannung des Motors;
Schritt 2: Durchführen einer inversen Clark-Transformation und einer inversen Park-Transformation für den d-Achsen-Strombefehlswert $i_{dref}$ und den q-Achsen-Strombefehlswert $i_{qref}$ des Motors, um einen U-Phasen-Stromreferenzwert $i_{uref}$, einen V-Phasen-Stromreferenzwert $i_{vref}$ und einen W-Phasen-Stromreferenzwert $i_{wref}$ zu erhalten;
Schritt 3: Berechnen einer Referenz-Negativsequenzkomponente $i_{urefNagtive}$ des U-Phasenstroms gemäß dem U-Phasenstrom-Referenzwert $i_{uref}$, dem V-Phasenstrom-Referenzwert $i_{vref}$ und dem W-Phasenstrom-Referenzwert $i_{wref}$;

Formeln zur Berechnung der Referenz-Negativsequenzkomponente des U-Phasenstroms $i_{urefNagtive}$ sind:

$$x_{bref} = i_{vref}(t) - i_{vref}(t - \Delta t)cos(\omega_e\Delta t) \cdot cot(\omega_e\Delta t) - i_{vref}(t - \Delta t)sin\omega_e\Delta t,$$

$$x_{cref} = i_{wref}(t) - i_{wref}(t - \Delta t)cos(\omega_e\Delta t) \cdot cot(\omega_e\Delta t) - i_{wref}(t - \Delta t)sin\omega_e\Delta t,$$

$$i_{urefNagtive} = \frac{1}{3}\left(i_{uref} - \frac{1}{2}i_{vref} - \frac{1}{2}i_{wref} + \frac{\sqrt{3}}{2}x_{cref} - \frac{\sqrt{3}}{2}x_{bref}\right),$$

**wobei** $i_{vref}(t)$ der Referenzwert des V-Phasen-Stroms zum Zeitpunkt t ist, $i_{wref}(t)$ der Referenzwert des W-Phasen-Stroms zum Zeitpunkt t ist, $i_{vref}(t - \Delta t)$ der Referenzwert des V-Phasen-Stroms zum Zeitpunkt$(t - \Delta t)$ ist, $i_{wref}(t - \Delta t)$ der Referenzwert des W-Phasen-Stroms zum Zeitpunkt$(t - \Delta t)$ ist und $\omega_e\Delta t$ die aktuelle Phasenpositionsdifferenz ist; Schritt 4: Berechnen einer Negativsequenzkomponente $i_{uNagtive}$ des U-Phasenstroms gemäß dem Dreiphasenstrom;
Formeln zur Berechnung der Negativsequenzkomponente$i_{uNagtive}$ des U-Phasenstroms sind:

$$x_b = i_v(t) - i_v(t - \Delta t)cot\omega_e\Delta t - i_v(t - \Delta t)sin\omega_e\Delta t,$$

$$x_c = i_w(t) - i_w(t - \Delta t)cot\omega_e\Delta t - i_w(t - \Delta t)sin\omega_e\Delta t,$$

$$i_{uNagtive} = \frac{1}{3}\left(i_u - \frac{1}{2}i_v - \frac{1}{2}i_w + \frac{\sqrt{3}}{2}x_c - \frac{\sqrt{3}}{2}x_b\right),$$

wobei $i_u$ der Rückkopplungswert des U-Phasenstroms ist, $i_v$ der Rücckkopplungswert des V-Phasenstroms ist, $i_w$ der Rückkopplungswert des W-Phasenstroms ist, $i_v(t)$ der Rückkopplungswert des V-Phasenstroms zum Zeitpunkt t ist, $i_w(t)$ der Rückkopplungswert des W-Phasenstroms zum Zeitpunkt t ist, $i_v(t - \Delta t)$ der Rückkopplungswert des V-Phasenstroms zum Zeitpunkt $(t - \Delta t)$ ist, $i_w(t - \Delta t)$ der Rückkopplungswert des W-Phasenstroms zum Zeitpunkt$(t - \Delta t)$ ist;
Schritt 5: Berechnen eines Differenzwerts $i_{urefNagtive} - i_{uNagtive}$ zwischen der Referenz-Negativsequenzkomponente des U-Phasenstroms $i_{urefNagtive}$ und der Negativsequenzkomponente des U-Phasenstroms $i_{uNagtive}$, wenn $i_{urefNagtive} - i_{uNagtive} \geq$ Stromanpassungswert $i_{threshold}$, wird der Fehlerzähler um eins erhöht, wenn $i_{urefNagtive} - i_{uNagtive} <$ Stromanpassungswert $i_{threshold}$, wird der Fehlerzähler um eins verringert;
Schritt 6: wenn der Fehlerzähler $\geq$ N ist, dann N setzen und einen Phasenausfall auslösen, und wenn der Fehlerzähler < N ist, dann Schritt 7 ausführen;
Schritt 7: wenn der Fehlerzähler < 0 ist, wird 0 gesetzt und es wird zu Schritt 1 zurückgekehrt, und wenn der Fehlerzähler $\geq$ 0 ist, wird direkt zu Schritt 1 zurückgekehrt.

**2.** Das Verfahren zur Phasenausfalldiagnose auf der Grundlage einer Strombefehlsrekonstruktion und einer Negativsequenzstrom-Extraktion gemäß Anspruch 1, wobei in Schritt 1 die Formeln zur Berechnung des d-Achsen-Stromanweisungswerts $i_{dref}$ und des q-Achsen-Stromanweisungswerts $i_{qref}$ wie folgt lauten:

$$i_{qref} = \frac{T_e}{1.5P_n[\psi_f + (L_d - L_q)i_d]},$$

$$\text{b} = \frac{2R_s\omega_e i_q(L_d - L_q) + 2\omega_e^2\psi_f L_d}{R_s^2 + \omega_e^2 L_d^2},$$

$$\text{c} = \frac{(R_s^2 + \omega_e^2 L_d^2)i_q^2 + 2R_s\omega_e i_q\psi_f + \omega_e^2\psi_f^2 - u_{lim}^2}{R_s^2 + \omega_e^2 L_d^2},$$

$$i_{dref} = \frac{-b + \sqrt{b^2 - 4c}}{2}$$

wobei $T_e$ das elektromagnetische Drehmoment ist, $P_n$ der Pol-Logarithmus des Motors, $\psi_f$ der Magnetfluss eines Permanentmagnetkörpers, $L_d$ die d-Achsen- -Induktivität des Motors, $L_q$ die q-Achsen-Induktivität des Motors, $i_d$ der d-Achsen-Strom des Motors, $R_s$ der Statorwiderstand des Motors, $\omega_e$ die Stromdrehzahl des Motors, $i_q$ der q-Achsen-Strom des Motors und $u_{lim}$ der verfügbare Spannungsgrenzwert.

**3.** Verfahren zur Phasenausfalldiagnose auf der Grundlage einer Strombefehlsrekonstruktion und einer Negativsequenzstrom-Extraktion gemäß Anspruch 1, wobei die Formeln zur Berechnung des U-Phasen-Strom-Referenzwerts $i_{uref}$, des V-Phasen-Strom-Referenzwerts $i_{vref}$ und des W-Phasen-Strom-Referenzwerts $i_{wref}$ lauten:

$$\begin{bmatrix} i_{uref} \\ i_{vref} \\ i_{wref} \end{bmatrix} = \begin{bmatrix} 1 & 0 \\ -\frac{1}{2} & \frac{\sqrt{3}}{2} \\ -\frac{1}{2} & -\frac{\sqrt{3}}{2} \end{bmatrix} \begin{bmatrix} \cos\theta & -\sin\theta \\ \sin\theta & \cos\theta \end{bmatrix} \begin{bmatrix} i_{dref} \\ i_{qref} \end{bmatrix},$$

$$i_{uref} = i_{dref}\cos\theta - i_{qref}\sin\theta,$$

$$i_{vref} = -\frac{1}{2}\left(i_{dref}cos\theta - i_{qref}sin\theta\right) + \frac{\sqrt{3}}{2}\left(i_{dref}sin\theta + i_{qref}cos\theta\right),$$

$$i_{wref} = -\frac{1}{2}\left(i_{dref}cos\theta - i_{qref}sin\theta\right) - \frac{\sqrt{3}}{2}\left(i_{dref}sin\theta + i_{qref}cos\theta\right)$$

wobei θ der Drehwinkel des d-q-Koordinatensystems ist.

**4.** Verfahren zur Phasenausfalldiagnose auf der Grundlage einer Strombefehlsrekonstruktion und einer Negativsequenzstrom-Extraktion gemäß Anspruch 1, wobei der Stromanpassungswert $i_{threshold}$ durch Anpassen des Stromabtastpegels an ein tatsächliches Produkt erhalten wird.

**5.** Verfahren zur Phasenausfalldiagnose auf der Grundlage einer Strombefehlsrekonstruktion und einer Extraktion des Gegenstroms gemäß Anspruch 1, wobei N gemäß einer Ausfalltoleranzzeit auf der Grundlage der funktionalen Sicherheit und einer Laufzeit einer Diagnosestrategie bestimmt wird.

## Revendications

**1.** Procédé de diagnostic de défaillance de phase basé sur la reconstruction d'instructions de courant et l'extraction de courant de séquence négative, comprenant les étapes suivantes :

étape 1, calcul d'une valeur d'instruction de courant d'axe d $i_{dref}$, d'une valeur d'instruction de courant d'axe q $i_{qref}$ d'un moteur en fonction d'un couple de courant, d'une vitesse de rotation et d'une tension du moteur ;
étape 2, réalisation d'une transformation inverse de Clark et d'une transformation inverse de Park sur la valeur d'instruction de courant d'axe d $i_{dref}$ et sur la valeur d'instruction de courant d'axe q $i_{qref}$ du moteur, pour obtenir une valeur de référence de courant de phase U $i_{uref}$, une valeur de référence de courant de phase V $i_{vref}$ et une valeur de référence de courant de phase W $i_{wref}$;
étape 3, calcul d'une composante de séquence négative de référence $i_{urefNagtive}$ du courant de phase U en fonction de la valeur de référence de courant de phase U $i_{uref}$, de la valeur de référence de courant de phase V $i_{vref}$ et de la valeur de référence de courant de phase W $i_{wref}$;
les formules de calcul de la composante de séquence négative de référence du courant de phase U $i_{urefNagetive}$ sont :

$$x_{bref} = i_{vref}(t) - i_{vref}(t - \Delta t)cos(\omega_e\Delta t) \cdot cot(\omega_e\Delta t) - i_{vref}(t - \Delta t)sin\omega_e\Delta t,$$

$$x_{cref} = i_{wref}(t) - i_{wref}(t - \Delta t)cos(\omega_e\Delta t) \cdot cot(\omega_e\Delta t) - i_{wref}(t - \Delta t)sin\omega_e\Delta t,$$

$$i_{urefNagtive} = \frac{1}{3}\left(i_{uref} - \frac{1}{2}i_{vref} - \frac{1}{2}i_{wref} + \frac{\sqrt{3}}{2}x_{cref} - \frac{\sqrt{3}}{2}x_{bref}\right),$$

dans lequel, $i_{vref}(t)$ est la valeur de référence de courant de phase V à l'instant t, $i_{wref}(t)$ est la valeur de référence de courant de phase W à l'instant t, $i_{vref}(t - \Delta t)$ est la valeur de référence de courant de phase V à l'instant $(t - \Delta t)$, $i_{wref}(t - \Delta t)$ est la valeur de référence de courant de phase W à l'instant $(t - \Delta t)$, et $\omega_e\Delta t$ est la différence de position de phase de courant ;

étape 4, calcul d'une composante de séquence négative $i_{uNagtive}$ du courant de phase U en fonction du courant triphasé ;

les formules de calcul de la composante de séquence négative $i_{uNagtive}$ du courant de phase U sont :

$$x_b = i_v(t) - i_v(t - \Delta t)cot\omega_e\Delta t - i_v(t - \Delta t)sin\omega_e\Delta t,$$

$$x_c = i_w(t) - i_w(t - \Delta t)cot\omega_e\Delta t - i_w(t - \Delta t)sin\omega_e\Delta t,$$

$$i_{uNagtive} = \frac{1}{3}\left(i_u - \frac{1}{2}i_v - \frac{1}{2}i_w + \frac{\sqrt{3}}{2}x_c - \frac{\sqrt{3}}{2}x_b\right),$$

dans lequel, $i_u$ est la valeur de retour de courant de phase U, $i_v$ est la valeur de retour de courant de phase V, $i_w$ est la valeur de retour de courant de phase W, $i_v(t)$ est la valeur de retour de courant de phase V à l'instant t, $i_w(t)$ est la valeur de retour de courant de phase W à l'instant t, $i_v(t - \Delta t)$ est la valeur de retour de courant de phase V à l'instant $(t - \Delta t)$, $i_w(t - \Delta t)$ est la valeur de retour de courant de phase W à l'instant $(t - \Delta t)$ ; étape 5, calcul d'une valeur de différence $i_{urefNagtive} - i_{uNagtive}$ entre la composante de séquence négative de référence du courant de phase U $i_{urefNagtive}$ et la composante de séquence négative du courant de phase U $i_{uNagtive}$, si $i_{urefNagtive} - i_{uNagtive} \geq$ valeur d'ajustement de courant $i_{threshold}$, le compteur de défaillances est augmenté d'une unité, si $i_{urefNagtive} - i_{uNagtive} <$ valeur d'ajustement de courant $i_{threshold}$, le compteur de défaillances est diminué d'une unité ;

étape 6, si le compteur de défaillances $\geq$ N, définir N et déclencher une défaillance de phase, et si le compteur de défaillances < N, exécuter l'étape 7 ;

étape 7, si le compteur de défaillances < 0, définir 0 et revenir à l'étape 1, et si le compteur de défaillance est $\geq$ 0, revenir directement à l'étape 1.

2. Procédé de diagnostic de défaillance de phase basé sur la reconstruction d'instructions de courant et l'extraction de courant de séquence négative selon la revendication 1, dans lequel, à l'étape 1, les formules de calcul de la valeur d'instruction de courant d'axe d $i_{dref}$ et de la valeur d'instruction de courant d'axe q $i_{qref}$ sont :

$$i_{qref} = \frac{T_e}{1.5P_n|\psi_f + (L_d - L_q)i_d|},$$

$$b = \frac{2R_s\omega_e i_q(L_d - L_q) + 2\omega_e^2\psi_f L_d}{R_s^2 + \omega_e^2 L_d^2},$$

$$c = \frac{(R_s^2 + \omega_e^2 L_d^2)i_q^2 + 2R_s\omega_e i_q\psi_f + \omega_e^2\psi_f^2 - u_{lim}^2}{R_s^2 + \omega_e^2 L_d^2},$$

$$i_{dref} = \frac{-b + \sqrt{b^2 - 4c}}{2},$$

dans lequel $T_e$ est le couple électromagnétique, $P_n$ est le logarithme polaire du moteur, $\psi_f$ est le flux magnétique d'un corps d'aimant permanent, $L_d$ est l'inductance d'axe d du moteur, $L_q$ est l'inductance d'axe q du moteur, $i_d$ est le courant d'axe d du moteur, $R_s$ est la résistance de stator du moteur, $\omega_e$ est la vitesse de rotation actuelle du moteur, $i_q$ est le courant d'axe q du moteur, $u_{lim}$ est la valeur limite de tension disponible.

3. Procédé de diagnostic de défaillance de phase basé sur la reconstruction d'instructions de courant et l'extraction de courant de séquence négative selon la revendication 1, dans lequel les formules de calcul de la valeur de référence de courant de phase U $i_{uref}$, de la valeur de référence de courant de phase V $i_{vref}$ et de la valeur de référence de courant de phase $W$ $i_{wref}$ sont :

$$\begin{bmatrix} i_{uref} \\ i_{vref} \\ i_{wref} \end{bmatrix} = \begin{bmatrix} 1 & 0 \\ -\frac{1}{2} & \frac{\sqrt{3}}{2} \\ -\frac{1}{2} & -\frac{\sqrt{3}}{2} \end{bmatrix} \begin{bmatrix} \cos\theta & -\sin\theta \\ \sin\theta & \cos\theta \end{bmatrix} \begin{bmatrix} i_{dref} \\ i_{qref} \end{bmatrix},$$

$$i_{uref} = i_{dref}\cos\theta - i_{qref}\sin\theta,$$

$$i_{vref} = -\frac{1}{2}\left(i_{dref}\cos\theta - i_{qref}\sin\theta\right) + \frac{\sqrt{3}}{2}\left(i_{dref}\sin\theta + i_{qref}\cos\theta\right),$$

$$i_{wref} = -\frac{1}{2}\left(i_{dref}\cos\theta - i_{qref}\sin\theta\right) - \frac{\sqrt{3}}{2}\left(i_{dref}\sin\theta + i_{qref}\cos\theta\right).$$

dans lequel $\theta$ est l'angle de rotation du système de coordonnées d-q.

4. Procédé de diagnostic de défaillance de phase basé sur la reconstruction d'instructions de courant et l'extraction de courant de séquence négative selon la revendication 1, dans lequel la valeur d'ajustement de courant $i_{threshold}$ est obtenue en ajustant le niveau d'échantillonnage de courant en fonction d'un produit réel.

5. Procédé de diagnostic de défaillance de phase basé sur la reconstruction d'instructions de courant et l'extraction de courant de séquence négative selon la revendication 1, dans lequel N est déterminé en fonction d'un temps de tolérance de défaillance basé sur la sécurité fonctionnelle et une période d'exécution d'une stratégie de diagnostic.

Fig. 1

START

Input the requested torque, motor rotation speed, bus voltage and motor parameter information under the current working condition

Calculate the reference current information under the current working condition, according to formulas 1 ~ 4

$i_{dref}$ $i_{qref}$

Transform d-axis and q-axis reference current to three-phase reference current by InvClark and InvPark transformation

$i_{uref}$ $i_{vref}$ $i_{wref}$

Obtain a negative sequence component of the U-phase refence current based on three-phase reference current by the formulas 9-11

$i_{urefNagtive}$

Sampl the three-phase feedback current

$i_{u}$ $i_{v}$ $i_{w}$

Obtain a negative sequence component of the U-phase refence current based on three-phase reference current by the formulas 9-11

$i_{uNagtive}$

$i_{uNagtive} - i_{urefNagtive} \geq i_{threshold}$

No

Yes

The failure counter increases one (Phase_debounce ++)

The failure counter decreases one (Phase_debounce --)

Phase_debounce >= N

No

Phase_debounce < 0

No

Yes

Yes

The failure counter is set to N (Phase_debounce = N)

The failure counter is set to zero (Phase_debounce = 0)

Output the phase failure mark and report the corresponding DEM

END

Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130077194 A1
- US 20100320953 A1

- EP 3696965 A1